# EUROPEAN PATENT APPLICATION

(11) **EP 4 521 339 A1**
(43) Date of publication of application: **12.03.2025**
(21) Application number: 23195416.5
(22) Date of filing: 05.09.2023
(51) Int. Cl.: G06T 7/11, G06T 7/136, G06T 7/73, G01R 33/44

(54) **AUTOMATIC NAVIGATOR ECHO PLACEMENT DETECTION**

(71) Applicant: Koninklijke Philips N.V., 5656 AG Eindhoven (NL)
(72) Inventor: HEGDE, Amruta Venkatraman, Eindhoven (NL); SHARMA, Sumit, Eindhoven (NL); P S, Viswanath, 5656AG Eindhoven (NL); SARASWATHY, Suja, Eindhoven (NL)
(74) Representative: Philips Intellectual Property & Standards

(57) **Abstract**

The present invention relates to a method of determining a position of a body landmark in a tomographic image slice of a subject, and a method of determining a positioning of a navigator echo in a three-dimensional preview image of a subject by consecutive application of the method of determining the position of the body landmark in at least three tomographic image slices of the subject in different viewing directions.

## Description

### FIELD OF THE INVENTION

The present invention relates to a computer-implemented method of determining a position of a body landmark in a tomographic image slice of a subject, a computer-implemented method of determining a positioning of a navigator echo, and a method of acquiring a tomographic image of a subject with a tomographic scanner.

### BACKGROUND OF THE INVENTION

Magnetic resonance imaging (MRI) is a widely used diagnostic tool that preferably requires a navigator echo to correct for motion artifacts during image acquisition. The navigator echo is a method employed in magnetic resonance imaging to mitigate the effects of motion artifacts that occur due to the patient's movement during the image acquisition process. This technique involves capturing a low-resolution image of the region of interest (ROI) before obtaining a high-resolution image. The navigator sequence entails obtaining one or more slices of the ROI in a plane perpendicular to the primary imaging sequence, using either similar or different parameters as the primary sequence. The navigator image can be taken quickly, typically within seconds, and serves to monitor the motion of the ROI during the acquisition of the high-resolution image. Throughout the high-resolution image acquisition, the navigator sequence is continually obtained to trace the motion of the ROI. The motion data extracted from the navigator sequence can then be utilized to modify the imaging parameters of the high-resolution sequence, such as gradient and RF pulse timings, to account for the motion of the ROI. This parameter modification is done in real-time to ensure that the acquired image is free of any motion-related artifacts. The navigator echo technique is especially valuable in imaging the chest and abdomen regions where respiratory motion can significantly affect the image quality. It can also account for motion caused by other factors like patient movement and cardiac motion. Ultimately, the navigator echo technique enhances image quality and reduces the need for repeated scans, saving time and reducing the overall cost of the MRI procedure. One simple commonly applied version of a navigator echo may be graphically placing a navigator pencil beam with dimensions of approximately 30x30x100 mm over the dome of the liver using a scout image.

However, the manual placement of navigator echoes on scout images could be a complicated task. The automatic detection of navigator echoes can improve the efficiency and reduce the expertise needed in placing the navigator echo in MRI image acquisition, thereby facilitating the diagnosis and treatment of various medical conditions.

The inventors of the present invention have thus found that it would be advantageous to have an improved method of determining a positioning of a navigator echo that ensures that navigator echoes are placed in optimal location resulting in better image quality.

### SUMMARY OF THE INVENTION

It is an object of the present invention to provide an improved method of determining a positioning of a navigator echo that provides reliable and accurate positioning.

The object of the present invention is solved by the subject matter of the independent claims, wherein further embodiments are incorporated in the dependent claims.

The described embodiments similarly pertain to the computer-implemented method of determining a position of a body landmark in a tomographic image slice of a subject, the computer-implemented method of determining a positioning of a navigator echo, and the method of acquiring a tomographic image of a subject with a tomographic scanner. The embodiments described further may be combined in any possible way. Synergistic effects may arise from different combinations of the embodiments although they might not be described in detail.

Further on, it shall be noted that all embodiments of the present invention concerning a method might be carried out with the order of the steps as described, nevertheless this has not to be the only and essential order of the steps of the method. The herein presented methods can be carried out with another order of the disclosed steps without departing from the respective method embodiment, unless explicitly mentioned to the contrary hereinafter.

According to a first aspect of the invention, there is provided a computer-implemented method of determining a position of a body landmark in a tomographic image slice of a subject. The method comprises the steps of receiving a tomographic image slice of a subject in a predefined view of the subject, the tomographic image slice comprising a region of interest of the subject, performing a threshold-based segmentation on the tomographic image slice, thereby segmenting the tomographic image slice into at least two body regions, and applying an edge detection algorithm on the segmented tomographic image slice, thereby determining an outer shape of at least one of the at least two body regions. The method comprises further the steps of determining a position of a center point of the outer shape of the at least one of the at least two body regions, and providing the position of the center point of the outer shape as the position of the body landmark in the tomographic image slice as an output of the method.

Thus, according to this method, a position of a body landmark in a tomographic image slice of a subject can be determined. The body landmark can be the uppermost point of the dome of the liver, or at least the uppermost point of the dome of the liver that is comprised in the respective image slice in the given view of the image slice. Therefore, a thresholding based segmentation algorithm is applied in order to segment, for example, the lung and/or the liver, and an edge detection algorithm can be applied on the segmented tomographic image slice, thereby determining an outer shape of at least one of the lung and the liver. Next, custom filters can be utilized to locate the lower edge of the lung that may correspond to the liver dome. Thus, as the outline of the dome of the liver in this image slice is determined, the topmost point of the outline can be determined, which may correspond to the dome of the liver, as long as the dome of the liver is comprised in this respective image slice. After that, a navigator beam can placed on the median of the liver dome curve as the required body landmark. However, it is noted that this proposed method may only work if the correct image slice is selected that contains already the dome of the liver. Thus, a novel three stage image processing based approach for automatically locating the liver dome in three dimensions and for placing a navigator tracker over it in MRI images is proposed, which is described in more detail below.

In an embodiment of the invention, the step of applying an edge detection algorithm on the segmented tomographic image slice comprises the sub-steps of applying the edge detection algorithm on the segmented tomographic image slice, thereby determining an outline of at least one of the at least two body regions, and applying at least one filter to the determined outline, thereby determining the outer shape of at least one of the at least two body regions.

In an embodiment of the invention, the step of applying an edge detection algorithm on the segmented tomographic image slice further comprises the sub-steps of performing a localization of the determined outer shape of the at least one of the at least two body regions with respect to the region of interest of the subject, and discarding a portion of the determined outer shape of the at least one of the at least two body regions that, as a result of the performed localization, is regarded as not being part of the region of interest of the subject.

In an embodiment of the invention, the body landmark is an uppermost point of the dome of the liver.

In an embodiment of the invention, the predefined view is selected from the group consisting of a sagittal view, a coronal view, and a transversal view.

In an embodiment of the invention, the region of interest comprises at least a part of the chest of the subject, in particular an interface of the lung and the liver of the subject.

In an embodiment of the invention, the threshold-based segmentation discriminates a tissue of the lung from a tissue of the liver.

In an embodiment of the invention, the center point of the outer shape of the at least one of the at least two body regions is an uppermost point of the outer shape in a superior-inferior direction of the subject.

According to another aspect of the invention, there is provided a computer-implemented method of determining a positioning of a navigator echo. The method comprises the steps of receiving a three-dimensional preview image of a subject acquired by a tomographic scanner, the preview image comprising a region of interest of the subject, determining a first tomographic image slice of the three-dimensional preview image, the first tomographic image slice being a center slice with respect to a region of interest of the subject in a coronal view of the subject, and determining a first position of a body landmark in the first tomographic image slice according to the method of any one of the preceding embodiments. The method comprises further the steps of determining a second tomographic image slice of the three-dimensional preview image, the second tomographic image slice being an image slice with respect to the region of interest of the subject in a sagittal view of the subject, the second tomographic image slice being perpendicular to the first tomographic image slice and containing the determined first position of the body landmark, and determining a second position of the body landmark in the second tomographic image slice according to the method of any one of the preceding embodiments. The method comprises further the steps of determining a third tomographic image slice of the three-dimensional preview image, the third tomographic image slice being an image slice with respect to the region of interest of the subject in a coronal view of the subject, the third tomographic image slice being perpendicular to the second tomographic image slice and parallel to the first tomographic image slice and containing the determined second position of the body landmark, determining a third position of the body landmark in the third tomographic image slice according to the method of any one of the preceding embodiments, and providing the positioning of the navigator echo based on the second position of the body landmark and the third position of the body landmark as an output of the method.

The use of the navigator echo has been demonstrated to be crucial for monitoring respiration and defining the location of the heart. This, in turn, facilitates enhanced imaging of the coronary and other cardiac areas. In order to locate the navigator tracker, it may be necessary to have knowledge of the shape of the liver dome. To achieve this, a three-step image processing approach is proposed that utilizes consecutive application of the method as described above in different images slices in different viewing directions.

Having determined a first tomographic image slice in coronal view, which may be a center slice of a region of interest, the position of a body landmark, i.e. the dome of the liver, is determined in this slice in coronal view, and the x-coordinate of the determined position is used for selecting a correct image slice in sagittal view, which in turn is used to determine the position of the body landmark in sagittal view. The determined respective coordinate of the body landmark in sagittal view is again utilized to determine a correct final image slice in coronal view. Having this correct coronal image slice available, the final position of the body landmark and thus the positioning of the navigator echo can be determined.

Performing the "Navigator Placement Procedure" three times as described above in a coronal view, a sagittal view, and again in a coronal view is necessary to find the correct position in all three dimensions for determining the correct positioning of the navigator.

Thus, according to this method, single-click automated navigator echo detection and placement is possible. In addition, in cardiac imaging, automatic navigator echo placement detection can be used to detect and place navigator echoes in the optimal location for cardiac gating, which may be critical for the acquisition of high-quality cardiac images. The placement of navigators can be challenging especially in patients with irregular breathing patterns. Automatic navigator echo placement detection can help to overcome that. Further, scan time can be reduced, as automatic navigator echo placement detection can be performed in only a few seconds. \

In an embodiment of the invention, the positioning of the navigator echo in a posterior-anterior direction of the subject is determined based on the second position of the body landmark, and wherein the positioning of the navigator echo in a dexter-sinister direction and in superior-inferior direction is determined based on the third position of the body landmark.

In an embodiment of the invention, the center slice is determined as being located in the middle of a range of the three-dimensional preview image, in the middle of the region of interest of the subject, and/or in the middle of the subject.

According to another aspect of the invention, there is provided a method of acquiring a tomographic image of a subject with a tomographic scanner. The method comprises the steps of acquiring a three-dimensional preview image of the subject, determining a positioning of a navigator echo in the preview image according to the method of any one of the preceding embodiments, and acquiring the tomographic image of the subject while correcting for a motion of the subject based on a movement of the positioning of the navigator echo.

According to another aspect of the invention, there is provided a data processing apparatus comprising means for carrying out the steps of the method according to any of the preceding embodiments.

According to another aspect of the invention, there is provided a computer program comprising instructions which, when the program is executed by a computer, cause the computer to carry out the steps of the method according to any of the preceding embodiments.

According to another aspect of the invention, there is provided a computer-readable storage medium comprising instructions which, when executed by a computer, cause the computer to carry out the steps of the method according to any of the preceding embodiments. Thus, the benefits provided by any of the above aspects equally apply to all of the other aspects and vice versa.

In summary, the invention relates to a method of determining a position of a body landmark in a tomographic image slice of a subject, and a method of determining a positioning of a navigator echo in a three-dimensional preview image of a subject by consecutive application of the method of determining the position of the body landmark in at least three tomographic image slices of the subject in different viewing directions.

One of the advantages of embodiments of the present invention is that the navigator echo placement in MRI scans can be efficiently automated. Another advantage may reside in that automatic navigator echo placement detection may ensure that navigator echoes are placed in optimal location resulting in better image quality, as the placement of navigator echoes is critical for accurate correction of motion-induced artifacts in MRI scans. Another advantage may reside in that automatic placement of navigator echoes ensures the consistency between different operators, as manual placement of navigator echoes can vary between operators resulting in inconsistencies in image quality. Another advantage may reside in that automatic navigator echo placement detection reduces the need of manual labor and experts and may be more cost effective.

These advantages are non-limiting and other advantages may be envisioned within the context of the present application.

The above aspects and embodiments will become apparent from and be elucidated with reference to the exemplary embodiments described hereinafter. Exemplary embodiments of the invention will be described in the following with reference to the following drawings:

### BRIEF DESCRIPTION OF THE DRAWINGS

Fig. 1 shows a block diagram of a computer-implemented method of determining a position of a body landmark in a tomographic image slice of a subject according to an embodiment of the invention.
Fig. 2 shows a block diagram of a computer-implemented method of determining a positioning of a navigator echo according to an embodiment of the invention.
Fig. 3 shows a flow diagram of a method of determining a position of a body landmark in a tomographic image slice of a subject according to an embodiment of the invention.
Fig. 4 shows a flow diagram of a method of determining a positioning of a navigator echo according to an embodiment of the invention.

### DETAILED DESCRIPTION OF EMBODIMENTS

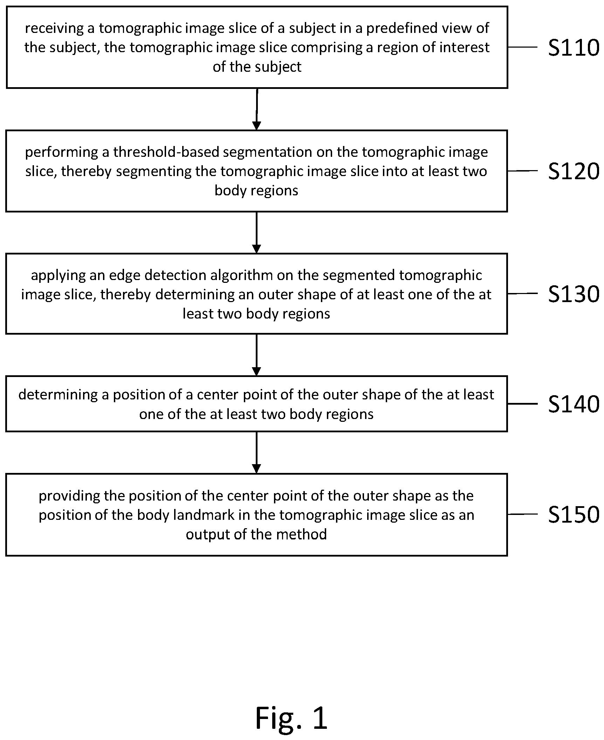

With respect to Fig. 1, a block diagram of a computer-implemented method of determining a position of a body landmark 120 in a tomographic image slice 110 of a subject according to an embodiment of the invention is illustrated. This method is also called navigator placement procedure. The method comprises the S110 of receiving a tomographic image slice 110 of a subject in a predefined view of the subject, where the tomographic image slice comprises a region of interest 130 of the subject. The method comprises further the step S120 of performing a threshold-based segmentation on the tomographic image slice 110, thereby segmenting the tomographic image slice into at least two body regions 140. The method comprises further the step S130 of applying an edge detection algorithm on the segmented tomographic image slice 110, thereby determining an outer shape of at least one of the at least two body regions 140. The method comprises further the step S140 of determining a position of a center point of the outer shape of the at least one of the at least two body regions, and the step S150 of providing the position of the center point of the outer shape as the position of the body landmark 120 in the tomographic image slice 110 as an output of the method.

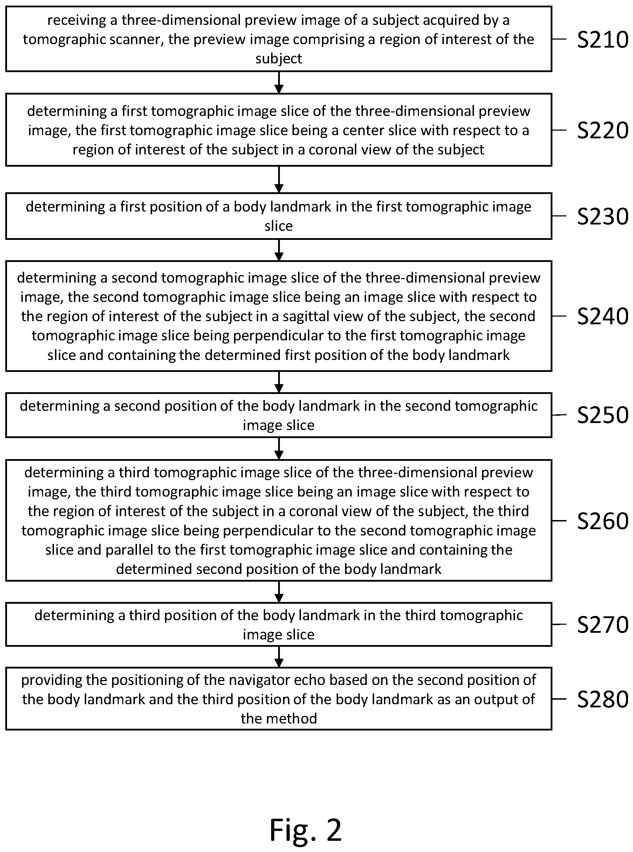

Fig. 2 shows a block diagram of a computer-implemented method of determining a positioning of a navigator echo according to an embodiment of the invention. The method comprises the step S210 of receiving a three-dimensional preview image of a subject acquired by a tomographic scanner, the preview image comprising a region of interest 130 of the subject, and the step S220 of determining a first tomographic image slice 111 of the three-dimensional preview image, the first tomographic image slice 111 being a center slice with respect to a region of interest 130 of the subject in a coronal view of the subject. The method comprises further the step S230 of determining a first position of a body landmark 120 in the first tomographic image slice 111 according to the navigator placement procedure as described above with respect to figure 1, and the step S240 of determining a second tomographic image slice 112 of the three-dimensional preview image, the second tomographic image slice 112 being an image slice with respect to the region of interest 130 of the subject in a sagittal view of the subject, the second tomographic image slice 112 being perpendicular to the first tomographic image slice 111 and containing the determined first position of the body landmark 120. The method comprises further the step S250 of determining a second position of the body landmark 120 in the second tomographic image slice 112 according to the navigator placement procedure as described above with respect to figure 1. The method comprises further the step S260 of determining a third tomographic image slice 113 of the three-dimensional preview image, the third tomographic image slice 113 being an image slice with respect to the region of interest 130 of the subject in a coronal view of the subject, the third tomographic image slice 113 being perpendicular to the second tomographic image slice 112 and parallel to the first tomographic image slice 111 and containing the determined second position of the body landmark 120. The method comprises further the step S270 of determining a third position of the body landmark 120 in the third tomographic image slice 113 according to the navigator placement procedure as described above with respect to figure 1, and the step S280 of providing the positioning of the navigator echo based on the second position of the body landmark 120 and the third position of the body landmark 120 as an output of the method.

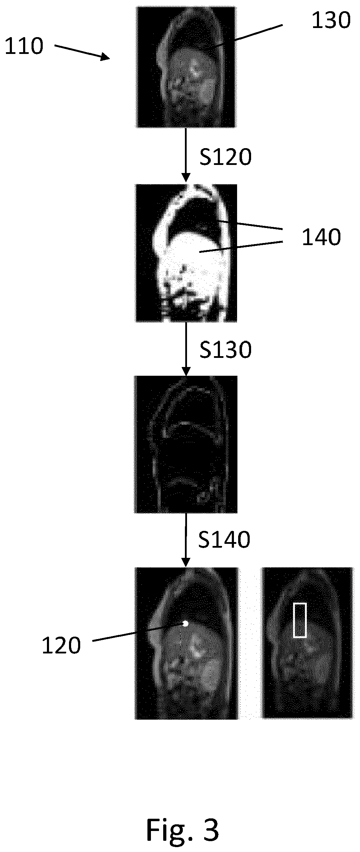

Fig. 3 shows a flow diagram of a method of determining a position of a body landmark 120 in a tomographic image slice 110 of a subject according to an embodiment of the invention. As shown in this exemplary illustration of Fig. 3, a sagittal view of the chest of a subject is used as tomographic image slice 110, which comprises the lung and the liver of the subject as region of interest 130. After applying the step S120 of performing the thresholding-based segmentation to distinguish the lung from the liver, the lung and the liver of the subject can be easily distinguished in the image slice as the two body regions 140 that need to be detected, and in particular the border region of these two body regions 140. After performing the step S130 of performing an edge detection on the output of the thresholding-based segmentation to capture the edge shape of the lung, the border region between the lung and the liver as the two body regions 140 is clearly highlighted. Optionally, custom-defined filters may be applied to the outline of the lung to only retain the shape of the dome of the liver, and more localization can be performed to avoid cases where the filters detect both the dome of the liver and the top of the lung, which usually may have a similar shape. Thus, additional noise in the image may be eliminated. Further, the processing steps applied to the respective tomographic image slice 110 comprise the step S140 of determining a position of the center point of the outline of the border between the lung and the liver and providing the coordinates of this center point as body landmark 120 as output.

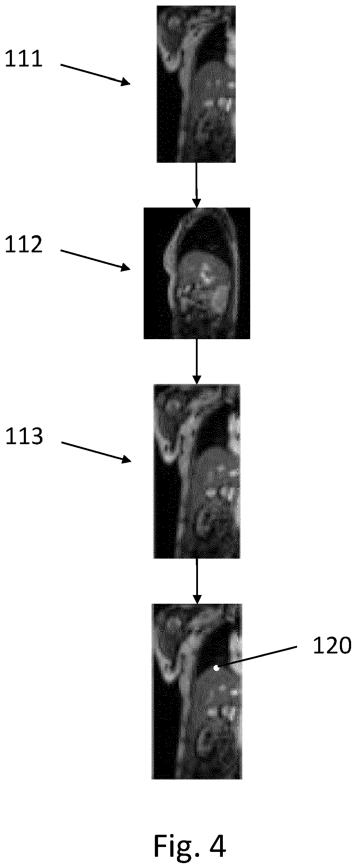

Fig. 4 shows a flow diagram of a method of determining a positioning of a navigator echo according to an embodiment of the invention. Therefore, according to the proposed method, the following steps may be necessary. An MRI scanner, for example, can acquire a three-dimensional smart survey image with a good image quality. The survey scan can either be free-breathing or breath-hold. The region of interest 130 can be determined, which may be the left half of the scan, which usually comprises the liver dome in the coronal view.

In order to localize the dome of the liver as navigator echo as body landmark in the region of interest, first, the correct dome placement in the sagittal view maybe determined. Therefore, it may be necessary to find a potential image slice for predicting the liver dome in the sagittal view. To do this, several processing steps are performed on a center or middle slice of the coronal view. After having determined the middle slice of the coronal view as first tomographic image slice 111, these steps are as follows, as also already described above.

The processing steps applied to the middle slice of the coronal view as first tomographic image slice 111 comprise at least performing a thresholding-based segmentation to distinguish the lung from the liver, and performing an edge detection on the output of the thresholding-based segmentation to capture the edge shape of the lung. Optionally, custom-defined filters may be applied to the outline of the lung to only retain the shape of the dome of the liver, and more localization can be performed to avoid cases where the filters detect both the dome of the liver and the top of the lung, which usually may have a similar shape. Thus, additional noise in the image may be eliminated. Further, the processing steps applied to the middle slice of the coronal view can comprise picking the center of the pixels left in the final output of the shape of the border between lung and liver.

After having applied these steps to the middle slice in the coronal view, the x-coordinate value of the determined center or topmost point of the outline found in the above process will be the slice number for predicting the liver dome in the sagittal view.

Having now defined the potential image slice for predicting the liver dome in the sagittal view as second tomographic image slice 112, the above-described processing steps are applied to this image slice in the sagittal view. In particular, thresholding-based segmentation to distinguish the lung from the liver is performed, edge detection on the output of the thresholding-based segmentation is applied to capture the edge shape of the lung, and the center of the pixels left in the final output of the shape of the border between lung and liver are selected. This will result in the correct navigator placement in the sagittal view.

Now, having the position of the navigator echo correctly placed in the correct slice in the sagittal view, the correct x-coordinate value of the point found from the above step in the sagittal view is utilized for determining the correct image slice in the coronal view as third tomographic image slice 113 and for performing the final detection of the position of the liver dome in this correct slice of the coronal view. Having now the correct slice of the coronal view determined, the steps as above-described are applied to this coronal third tomographic image slice 113. In particular, thresholding-based segmentation to distinguish the lung from the liver is performed, edge detection on the output of the thresholding-based segmentation is applied to capture the edge shape of the lung, and the center of the pixels left in the final output of the shape of the border between lung and liver are selected.

The output of this application of the described steps in the correct coronal view will be the final estimation of the body landmark 120 to be determined as the navigator echo placement.

Performing the "navigator placement procedure" three times as described above in a coronal view, a sagittal view, and again in a coronal view may be necessary to find the correct position in all three dimensions for determining the correct positioning of the navigator echo. The proposed method was evaluated on 60 clinical MRI datasets and it achieved an accuracy of 96.7% in detecting the correct placement of navigator echoes.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

In the claims, the word "comprising" does not exclude other elements or steps, and the indefinite article "a" or "an" does not exclude a plurality. The mere fact that certain measures are re-cited in mutually different dependent claims does not indicate that a combination of these measures cannot be used to advantage. Any reference signs in the claims should not be construed as limiting the scope.

### LIST OF REFERENCE SIGNS:

- 110: tomographic image slice
- 111: first tomographic image slice
- 112: second tomographic image slice
- 113: third tomographic image slice
- 120: body landmark
- 130: region of interest
- 140: two body regions

## Claims

1. A computer-implemented method of determining a position of a body landmark (120) in a tomographic image slice (110) of a subject, the method comprising the steps of:
receiving (S110) a tomographic image slice (110) of a subject in a predefined view of the subject, the tomographic image slice comprising a region of interest (130) of the subject;
performing (S120) a threshold-based segmentation on the tomographic image slice (110), thereby segmenting the tomographic image slice into at least two body regions (140);
applying (S130) an edge detection algorithm on the segmented tomographic image slice (110), thereby determining an outer shape of at least one of the at least two body regions (140);
determining (S140) a position of a center point of the outer shape of the at least one of the at least two body regions; and
providing (S150) the position of the center point of the outer shape as the position of the body landmark (120) in the tomographic image slice (110) as an output of the method.

2. The method according to claim 1, wherein the step of applying an edge detection algorithm on the segmented tomographic image (110) slice comprises the sub-steps of:
applying the edge detection algorithm on the segmented tomographic image slice (110), thereby determining an outline of at least one of the at least two body regions (140); and
applying at least one filter to the determined outline, thereby determining the outer shape of at least one of the at least two body regions (140).

3. The method according to claim 2, wherein the step of applying an edge detection algorithm on the segmented tomographic image slice (110) further comprises the sub-steps of:
performing a localization of the determined outer shape of the at least one of the at least two body regions (140) with respect to the region of interest (130) of the subject; and
discarding a portion of the determined outer shape of the at least one of the at least two body regions (140) that, as a result of the performed localization, is regarded as not being part of the region of interest (130) of the subject.

4. The method according to any of the preceding claims, wherein the body landmark (120) is an uppermost point of the dome of the liver.

5. The method according to any of the preceding claims, wherein the predefined view is selected from the group consisting of a sagittal view, a coronal view, and a transversal view.

6. The method according to any of the preceding claims, wherein the region of interest comprises at least a part of the chest of the subject, in particular an interface of the lung and the liver of the subject.

7. The method according to any of the preceding claims, wherein the threshold-based segmentation discriminates a tissue of the lung from a tissue of the liver.

8. The method according to any of the preceding claims, wherein the center point of the outer shape of the at least one of the at least two body regions (140) is an uppermost point of the outer shape in a superior-inferior direction of the subject.

9. A computer-implemented method of determining a positioning of a navigator echo, the method comprising the steps of:
receiving (S210) a three-dimensional preview image of a subject acquired by a tomographic scanner, the preview image comprising a region of interest (130) of the subject;
determining (S220) a first tomographic image slice (111) of the three-dimensional preview image, the first tomographic image slice (111) being a center slice with respect to a region of interest (130) of the subject in a coronal view of the subject;
determining (S230) a first position of a body landmark (120) in the first tomographic image slice (111) according to the method of any one of claims 1 to 8;
determining (S240) a second tomographic image slice (112) of the three-dimensional preview image, the second tomographic image slice (112) being an image slice with respect to the region of interest (130) of the subject in a sagittal view of the subject, the second tomographic image slice (112) being perpendicular to the first tomographic image slice (111) and containing the determined first position of the body landmark (120);
determining (S250) a second position of the body landmark (120) in the second tomographic image slice (112) according to the method of any one of claims 1 to 8;
determining (S260) a third tomographic image slice (113) of the three-dimensional preview image, the third tomographic image slice (113) being an image slice with respect to the region of interest (130) of the subject in a coronal view of the subject, the third tomographic image slice (113) being perpendicular to the second tomographic image slice (112) and parallel to the first tomographic image slice (111) and containing the determined second position of the body landmark (120);
determining (S270) a third position of the body landmark (120) in the third tomographic image slice (113) according to the method of any one of claims 1 to 8; and
providing (S280) the positioning of the navigator echo based on the second position of the body landmark (120) and the third position of the body landmark (120) as an output of the method.

10. The method according to claim 9, wherein the positioning of the navigator echo in a posterior-anterior direction of the subject is determined based on the second position of the body landmark (120), and wherein the positioning of the navigator echo in a dexter-sinister direction and in superior-inferior direction is determined based on the third position of the body landmark (120).

11. The method according to any of claims 9 or 10, wherein the center slice is determined as being located in the middle of a range of the three-dimensional preview image, in the middle of the region of interest (130) of the subject, and/or in the middle of the subject.

12. A method of acquiring a tomographic image of a subject with a tomographic scanner, the method comprising the steps of:
acquiring a three-dimensional preview image of the subject;
determining a positioning of a navigator echo in the preview image according to the method of any one of claims 9 to 11; and
acquiring the tomographic image of the subject while correcting for a motion of the subject based on a movement of the positioning of the navigator echo.

13. A data processing apparatus comprising means for carrying out the steps of the method according to any of claims 1 to 11.

14. A computer program comprising instructions which, when the program is executed by a computer, cause the computer to carry out the steps of the method according to any of claims 1 to 11.

15. A computer-readable storage medium comprising instructions which, when executed by a computer, cause the computer to carry out the steps of the method according to any of claims 1 to 11.
